# EUROPEAN PATENT APPLICATION

(11) **EP 4 734 740 A2**
(43) Date of publication of application: **29.04.2026**
(21) Application number: 25209743.1
(22) Date of filing: 20.10.2025
(51) Int. Cl.: H10W 40/22, H10W 40/73

(54) **HEAT DISSIPATION ASSEMBLY**

(30) Priority: 21.10.2024 US 202463709919 P; 16.01.2025 TW 114101911
(71) Applicant: Industrial Technology Research Institute, 310401 Hsinchu (TW)
(72) Inventor: Zhang, Wen-Hua, Zhubei City, Hsinchu County 302, R.O.C. (TW); Ting, Shuan-Hseng, Taoyuan City, R.O.C. (TW); Liu, Yang-Guang, Xinfeng Township, Hsinchu County, R.O.C. (TW); Liaw, Jane-Sunn, Taichung City, R.O.C. (TW); Wang, Chien-Chang, Hsinchu City, R.O.C. (TW)
(74) Representative: dompatent

(57) **Abstract**

A heat dissipation assembly (10, 10a, 10b, 10c, 10d, 10e, 10f, 10g) including first chamber (100, 100a, 100d, 100e, 100g), connecting chambers (200), first heat sinks (300) and second chamber (500, 500b, 500d, 500e). The first chamber has thermal contact surface (131, 131d) and first inner space (S1). The thermal contact surface is in thermal contact with heat source (20, 20c, 20d). The connecting chambers each include at least one communicating channel (210) in fluid communication with the first inner space. The first heat sinks are disposed between the connecting chambers, respectively. The second inner space (S2, S2b) is in fluid communication with the first inner space via communicating channel. A normal direction (N) of the thermal contact surface is parallel to extending direction (E) of communicating channel of connecting chambers. The communicating channel is entirely located between first and second inner spaces.

## Description

### Technical Field

The disclosure relates to a heat dissipation assembly, more particularly to a heat dissipation assembly including heat sink.

### Background

Recently, a heat dissipation assembly configured by a vapor chamber, a heat sink and one or more heat pipes is widely used in various electronic devicses to cool one or more heat sources. In such heat dissipation assembly, the heat pipes stand on a side of the vapor chamber and are disposed through the heat sink. In addition, one or more wick structures are disposed in each of the vapor chamber and the heat pipes to facilitate the circulation of a working fluid therein.

However, the wick structures occupy the space in the vapor chamber or the heat pipe, thereby reducing the cooling capacity of the vapor chamber or the heat pipe by disturbing the flow of the working fluid therein. In addition, the heat pipe is required to have a large volume to accommodate the wick structures, which causes the cold air to be blocked by the heat pipe and thus is unable to efficiently flow to some region on the heat sink. As discussed above, conventional heat dissipation assembly has a problem of having low cooling capacity.

### SUMMARY

The disclosure is to provide a heat dissipation assembly whose cooling capacity and heat dissipation efficiency are both improved.

A heat dissipation assembly disclosed by one embodiment of the disclosure is configured to be in thermal contact with at least one heat source and includes a first chamber, a plurality of connecting chambers, at least one first heat sink and a second chamber. The first chamber includes a base, a bottom communicating plate and a bottom supporting structure. The base has a bottom communicating recess and a thermal contact surface. The thermal contact surface is configured to be in thermal contact with the at least one heat source. The bottom communicating plate is disposed on a side of the base and has a plurality of bottom communicating holes. The plurality of bottom communicating holes are in fluid communication with the bottom communicating recess. The bottom communicating recess and the plurality of bottom communicating holes together form a first inner space. The bottom supporting structure is disposed in the bottom communicating recess and includes a plurality of bottom supporting columns spaced apart from each other. Two opposite ends of each of the plurality of bottom supporting columns are connected to the base and the bottom communicating plate, respectively. The plurality of connecting chambers are disposed on a side of the first chamber and each have at least one communicating channel. The communicating channels of the plurality of connecting chambers are in fluid communication with the plurality of bottom communicating holes, respectively. The at least one first heat sink is disposed between the plurality of connecting chambers. The second chamber is disposed on a sides of the plurality of connecting chambers located away from the first chamber and has a second inner space. The second inner space is in fluid communication with the first inner space via the at least one communicating channel of one of the plurality of connecting chambers.

According to the heat dissipation assembly disclosed by above embodiments, the first heat sinks are respectively disposed between the connecting chambers, and the communicating channels are in fluid communication with the first inner space. Thus, the working fluid is allowed to circulate between the first inner space and the communicating channels via thermosiphon principle or effect, such that the wick structures in the first inner space and the communicating channels are allowed to be selectively omitted. In this way, more working fluid is allowed to be accommodated in the heat dissipation assembly, and the maximum amount of heat that the heat dissipation assembly is able to conduct and the heat capacity per unit volume of the heat dissipation assembly are significantly increased. Moreover, the connecting chambers without wick structure is allowed to have smaller volume, thereby allowing the cooling airflow to flow through the first heat sinks uniformly. Accordingly, the heat dissipation assembly is allowed to cool the heat source more efficiently.

In addition, since the wick structures are allowed to be omitted from the connecting chambers, the connecting chambers are allowed to be made of various materials. For example, the heat dissipation assembly may be made of a material with lower density to realize the lightweight thereof.

Moreover, since the second inner space is in fluid communication with the first inner space via the communicating channels of the connecting chambers, the pressure distribution in the second inner space is uniform, thereby allowing the working fluid to be distributed to the communicating channels uniformly. In this way, the working fluid circulates between the first inner space, the communicating channels and the second inner space more efficiently, thereby further allowing the heat dissipation assembly to cool the heat source more efficiently.

In addition, the bottom supporting columns are spaced apart from each other and two opposite ends of each bottom supporting column are connected to the base and the bottom communicating plate. Thus, the working fluid is allowed to flow through the gaps between the bottom supporting columns, thereby facilitating the flow of the working fluid in the bottom communicating recess. Also, for example, the base, the bottom communicating plate and the bottom supporting structure are allowed to be integrally formed as a single piece. In this way, the cooling capacity of the heat dissipation assembly is improved while enhancing the structural strength of the first chamber.

### BRIEF DESCRIPTION OF THE DRAWINGS

The present disclosure will become better understood from the detailed description given herein below and the accompanying drawings which are given by way of illustration only and thus are not intending to limit the present disclosure and wherein:
FIG. 1 is a perspective view of a heat dissipation assembly according to a first embodiment of the disclosure;
FIG. 2 is a partially enlarged exploded view of the heat dissipation assembly in FIG. 1;
FIG. 3 is another partially enlarged exploded view of the heat dissipation assembly in FIG. 1;
FIGS. 4 and 5 are cross-sectional views of the heat dissipation assembly in FIG. 1 and a heat source;
FIG. 6 is another partially enlarged exploded view of the heat dissipation assembly in FIG. 1;
FIG. 7 is another partially enlarged exploded view of the heat dissipation assembly in FIG. 1;
FIG. 8 is a perspective view of a heat dissipation assembly according to a second embodiment of the disclosure;
FIG. 9 is a partially enlarged exploded view of the heat dissipation assembly in FIG.8;
FIG. 10 is a perspective view of a heat dissipation assembly according to a third embodiment of the disclosure;
FIG. 11 is a partially enlarged exploded view of the heat dissipation assembly in FIG.10;
FIG. 12 is another partially enlarged exploded view of the heat dissipation assembly in FIG. 10;
FIG. 13 is a side view of a heat dissipation assembly according to a fourth embodiment of the disclosure and heat sources;
FIG. 14 is a bottom view of the heat sources and the heat dissipation assembly in FIG. 13;
FIG. 15 is a cross-sectional view of a heat dissipation assembly according to a fifth embodiment of the disclosure and heat sources; and
FIG. 16 is a bottom view of the heat sources and the heat dissipation assembly in FIG. 15;
FIG. 17 is a cross-sectional view of a heat dissipation assembly according to a sixth embodiment of the disclosure;
FIG. 18 is another cross-sectional view of the heat dissipation assembly in FIG. 17;
FIG. 19 is still another cross-sectional view of the heat dissipation assembly in FIG. 17;
FIG. 20 is a perspective view of a heat dissipation assembly according to a seventh embodiment of the disclosure; and
FIG. 21 is a perspective view of a heat dissipation assembly according to an eighth embodiment of the disclosure.

### DETAILED DESCRIPTION

In the following detailed description, for purpose of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

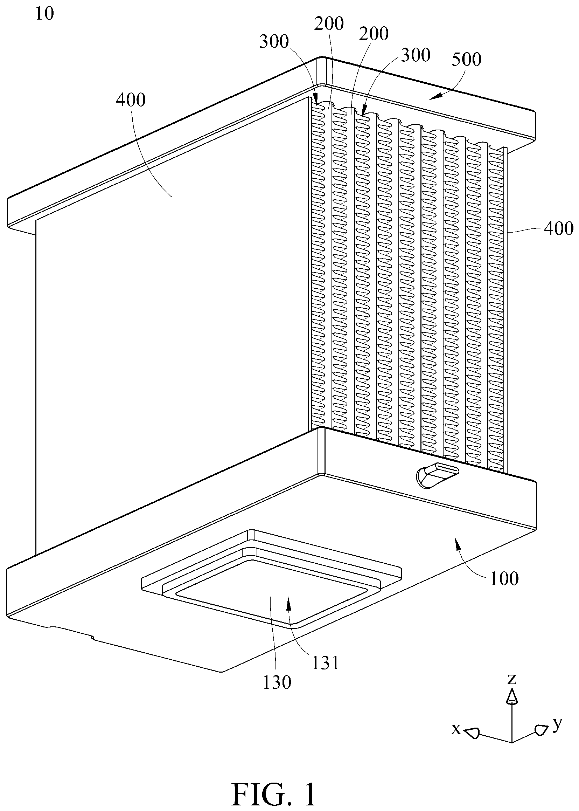

Please refer to FIG. 1 that is a perspective view of a heat dissipation assembly according to a first embodiment of the disclosure. In this embodiment, the heat dissipation assembly 10 includes a first chamber 100, a plurality of connecting chambers 200, a plurality of first heat sinks 300, two air blocking plates 400 and a second chamber 500. The first chamber 100, the connecting chambers 200 and the second chamber 500 are configured for a working fluid (not shown) to circulate therein by phase transition between liquid and gas. The working fluid is, for example, refrigerant, but the disclosure is not limited thereto. The working fluid may be water, fluorinated liquid, or methanol. The heat dissipation assembly 10 may be applied in, for example, a charging pile or various specifications or sizes (e.g., height) of servers, and may be used to cool a high-end chip in next generation, a silicon photonic chip, various electronic modules and various Insulated Gate Bipolar Transistor (IGBT) power modules in a high-end server or the like.

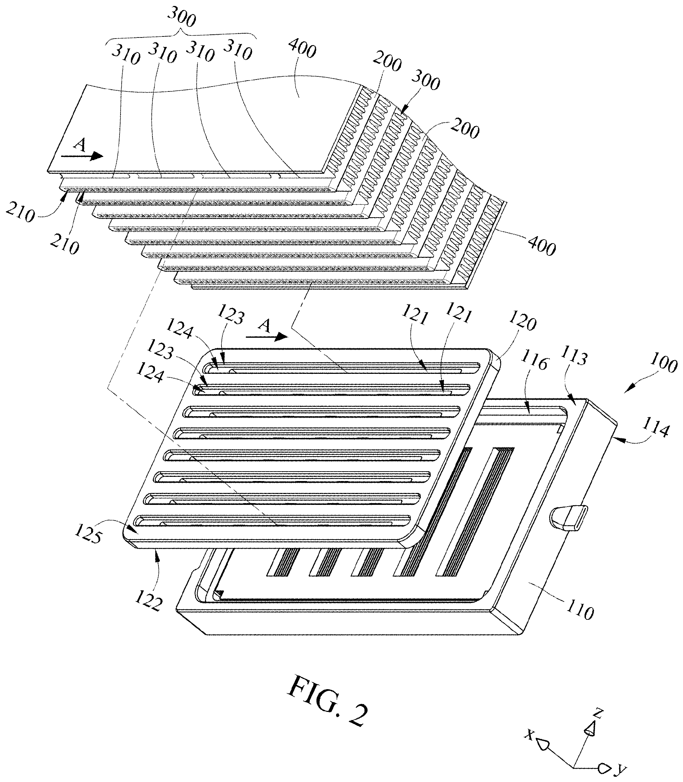

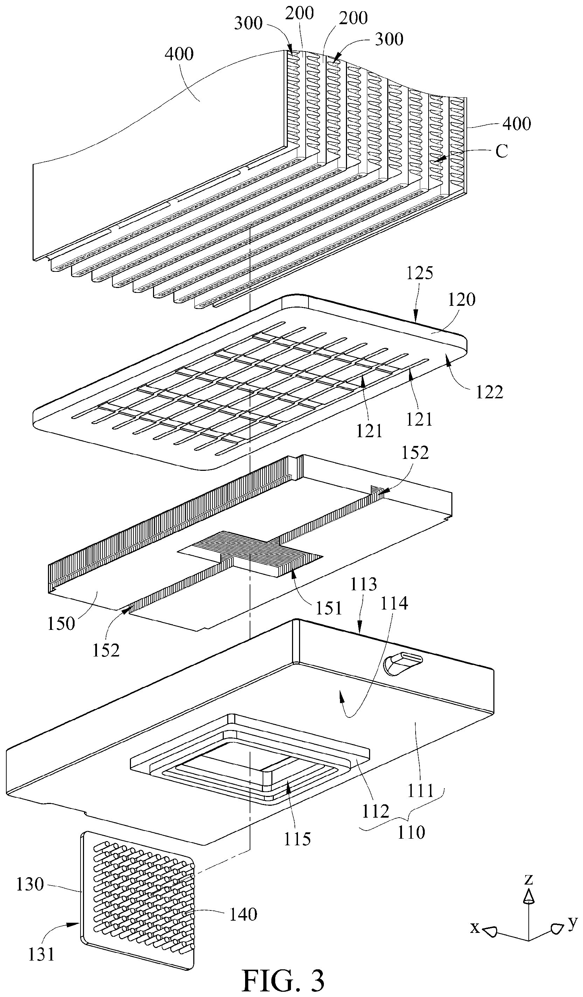

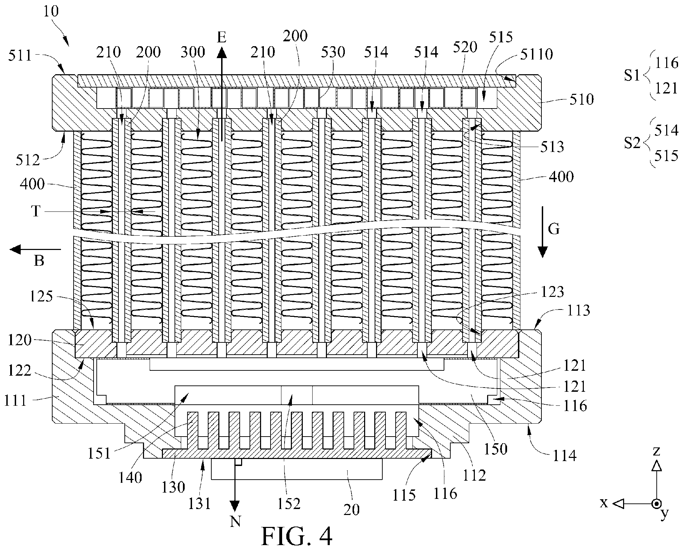

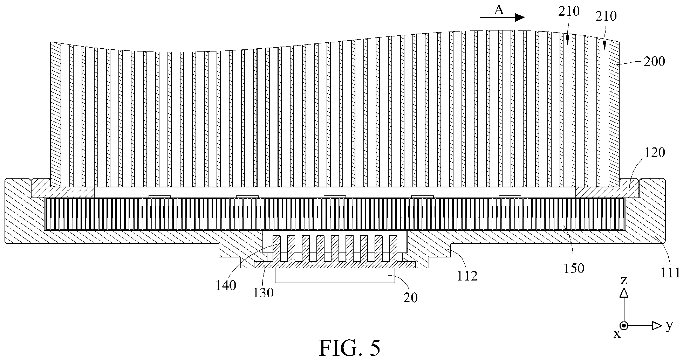

Please refer to FIGS. 2 to 5. FIG. 2 is a partially enlarged exploded view of the heat dissipation assembly in FIG. 1. FIG. 3 is another partially enlarged exploded view of the heat dissipation assembly in FIG. 1. FIGS. 4 and 5 are cross-sectional views of the heat dissipation assembly in FIG. 1 and a heat source.

In this embodiment, for example, the first chamber 100 includes a base 110, a bottom communicating plate 120, a bottom cover plate 130, a second heat sink 140 and a bottom supporting structure 150, and has a first inner space S1.

In this embodiment, the base 110 includes, for example, a body part 111 and a protruding part 112. The body part 111 has a top surface 113 and a bottom surface 114 facing away from each other. The protruding part 112 protrudes outwards from the bottom surface 114, and has an opening 115. The opening 115 is located on a side of the protruding part 112 located away from the body part 111.

The first inner space S1 includes, for example, a bottom communicating recess 116 and a plurality of bottom communicating holes 121. The bottom communicating recess 116 is recessed inwards from the top surface 113, and is in fluid communication with the opening 115.

In this embodiment, the bottom communicating plate 120 is disposed in the bottom communicating recess 116, and has a top surface 125, a bottom surface 122 and a plurality of bottom mounting recesses 123. The top surface 125 and the bottom surface 122 face away from each other. The bottom surface 122 faces toward the protruding part 112. The bottom communicating holes 121 are located on the bottom communicating plate 120. The bottom communicating holes 121 extend along an arranging direction A (parallel to Y-axis direction). The bottom mounting recesses 123 are located on the top surface 125. The bottom communicating holes 121 penetrate through a plurality of bottom surfaces 124 of the bottom mounting recesses 123 and the bottom surface 122, respectively.

The bottom cover plate 130 is fixed in the opening 115 via, for example, soldering or welding. The bottom cover plate 130 is located on a side of the protruding part 112 located away from the body part 111. That is, the bottom cover plate 130 is disposed on the bottom surface 114 via the protruding part 112. Further, the bottom cover plate 130 has a thermal contact surface 131. The thermal contact surface 131 is configured to be in thermal contact with the heat source 20. The heat source 20 is, for example, an electronic component having high power, such as a central processing unit (CPU) and a graphic processing unit (GPU). The bottom cover plate 130 is located above the heat source 20 along a gravitational direction G.

The second heat sink 140 is disposed on the bottom cover plate 130, and is located in the bottom communicating recess 116. In this embodiment, the second heat sink 140 is, for example, a pin fin. A surface treatment may be performed on an inner surface of the bottom cover plate 130 facing away from the thermal contact surface 131 or the second heat sink 140, so as to increase the surface roughness of the said inner surface or the second heat sink 140, thereby facilitating the phase transition of the working fluid.

The bottom supporting structure 150 is fixed to the body part 111 of the base 110 via, for example, soldering or welding. The bottom supporting structure 150 is located in the bottom communicating recess 116. The bottom supporting structure 150 prevents the base 110 from being deformed or destroyed when a vacuum pumping is performed in the bottom communicating recess 116 or the working fluid in the bottom communicating recess 116 is heated to form positive pressure. In this embodiment, the bottom supporting structure 150 is, for example, a U-shaped fin formed by stacking a plurality of U-shaped fin units. Note that besides the U-shaped fin, the bottom supporting structure 150 may be a skived fin, a stack fin, a pin fin, an I-shaped fin or an offset-strip fin. Moreover, the bottom supporting structure 150 has, for example, a recess 151 and two return channels 152. The two return channels 152 are in fluid communication with the recess 151, and are located on two opposite sides of the recess 151, respectively. The two return channels 152 extend along the arranging direction A. The second heat sink 140 is located between the recess 151 and the bottom cover plate 130.

In this embodiment, there are, for example, eight connecting chambers 200. The connecting chambers 200 each have a plurality of communicating channels 210. The communicating channels 210 of each connecting chamber 200 are arranged and spaced apart from one another along the arranging direction A. The bottom communicating holes 121 allow the communicating channels 210 of the connecting chambers 200 to be in fluid communication with the bottom communicating recess 116, respectively. Sides of the connecting chambers 200 are fixed in the bottom mounting recesses 123, respectively. The connecting chambers 200 each have a thickness T along X-axis direction ranging, for example, from 0.5 millimeter (mm) to 5 mm, preferably from 1 mm to 3 mm, more preferably being 2 mm or 3 mm. In other embodiments, the connecting chambers may each have one communicating channel. Furthermore, the communicating channels 210 may be in an arbitrary shape, such as an irregular shape, a triangular shape, a circular shape, an oval shape, and an eclipse shape, and there may be more than three (e.g., ten or twelve) communicating channels 210.

The connecting chambers 200 are located between the first heat sinks 300, respectively. The first heat sinks 300 are in, for example, a wave shape, or may be referred as folded fins. In other embodiments, the first heat sinks 300 may each be a stack fin, such as a zipper fin, a U-shape fin or an I-shaped fin. The two air blocking plates 400 are disposed on two outermost first heat sinks 300, respectively. The connecting chambers 200 and the first heat sinks 300 are located between the two air blocking plates 400. The first heat sinks 300 are fixed to the connecting chambers 200 and the two air blocking plates 400 via, for example, soldering or welding. An external fan (not shown) may, for example, blow a cooling airflow C flowing through the first heat sinks 300. In this embodiment, the air blocking plates 400 are plates without any channel, and are used to block the airflow (i.e., allow the cooling airflow C to flow through the first heat sinks 300 in a more concentrate manner) and support the first heat sinks 300, but the disclosure is not limited thereto. In other embodiments, the air blocking plates and the connecting chambers may have similar structures. That is, in other embodiments, the two air blocking plates may be replaced by two additional connecting chambers.

In this embodiment, the first heat sinks 300 each include, for example, a plurality of fin parts 310. The fin parts 310 of each first heat sink 300 are spaced apart from one another along the arranging direction A. That is, the first heat sinks 300 in this embodiment have a segmented design, which reduces the manufacture cost of the first heat sinks 300. Moreover, similarly, in other embodiments, each connecting chamber may include multiple parts that are spaced apart from one another along the arranging direction to reduce the manufacture cost of the connecting chambers. In addition, in other embodiments, if there is no demand for reducing the manufacture cost, the fin parts of each first heat sink may be integrally formed as a single piece.

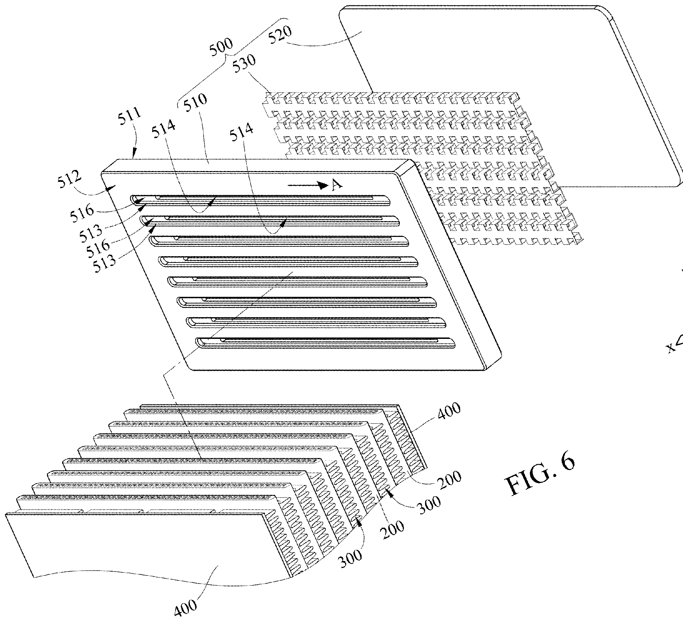

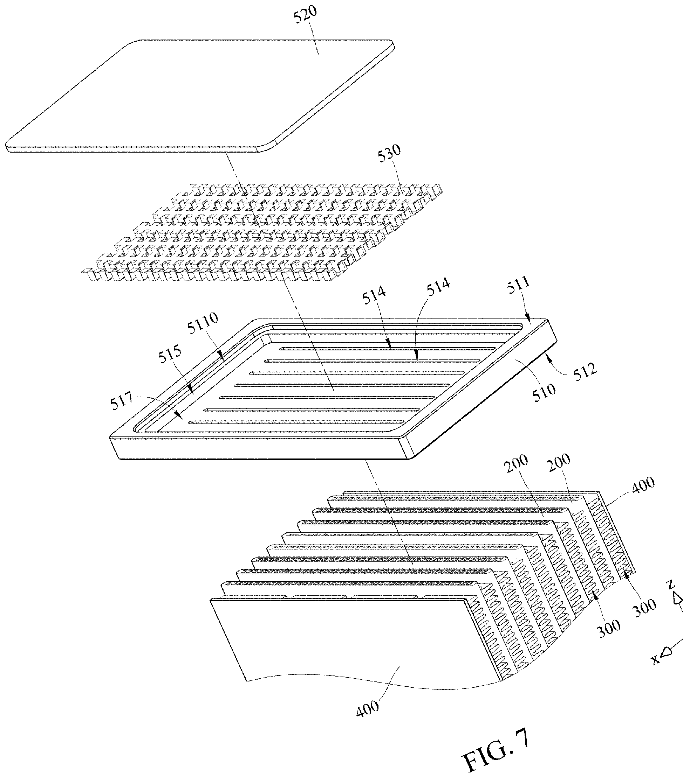

Please refer to FIGS. 4, 6 and 7. FIG. 6 is another partially enlarged exploded view of the heat dissipation assembly in FIG. 1. FIG. 7 is another partially enlarged exploded view of the heat dissipation assembly in FIG. 1.

In this embodiment, for example, the second chamber 500 includes a top communicating plate 510, a top cover plate 520 and a top supporting structure 530, and has a second inner space S2.

The top communicating plate 510 has a top surface 511, a bottom surface 512 and a plurality of top mounting recesses 513. The top surface 511 faces away from the bottom surface 512. The top mounting recesses 513 are located on the bottom surface 512.

The second inner space S2 includes, for example, a plurality of top communicating holes 514 and a top communicating recess 515. The top communicating holes 514 are located on the top communicating plate 510, and extend along the arranging direction A. The top communicating recess 515 is recessed from the top surface 511 and is in fluid communication with the top communicating holes 514. The top communicating holes 514 penetrate through a plurality of bottom surfaces 516 of the top mounting recesses 513 and a bottom surface 517 of the top communicating recess 515, respectively.

The top communicating holes 514 are in fluid communication with the communicating channels 210 of the connecting chambers 200, respectively. As shown in FIG. 4, the second inner space S2 is in fluid communication with the first inner space S1 via the communicating channels 210. Specifically, the top communicating recess 515 of the second inner space S2 is in fluid communication with the first inner space S1 of the bottom communicating recess 116 via the top communicating holes 514, the communicating channels 210 and the bottom communicating holes 121. Other sides of the connecting chambers 200 are fixed in the top mounting recesses 513, respectively. As shown in FIG. 4, two opposite sides of the connecting chambers 200 are fixed in the bottom mounting recesses 123 and the top mounting recesses 513 via soldering or welding, respectively. With the bottom mounting recesses 123 and the top mounting recesses 513, the fluid communication between the bottom communicating recess 116 and the top communicating recess 515 is ensured by the communicating channels 210 while allowing the connecting chambers 200 to be soldered or welded in the bottom mounting recesses 123 and the top mounting recesses 513. As shown in FIGS. 2 and 6, in this embodiment, two opposite sides of the connecting chambers 200 rest on the bottom surfaces 124 of the bottom mounting recesses 123 and the bottom surfaces 516 of the top mounting recesses 513, respectively, thereby facilitating the positioning of the connecting chambers 200. However, the disclosure is not limited thereto. In other embodiments, the bottom mounting recesses may penetrate through the bottom surface and the top surface of the bottom communicating plate, and thus sides of the connecting chambers are entirely fixed in the bottom mounting recesses. In such embodiments, the bottom mounting recesses of the bottom communicating plate may not have the bottom surface, and an external jig or fixture may be used to position the connecting chamber, thereby saving the cost for forming the bottom surface. Note that the top mounting recesses and the top communicating plate may be modified in a similar manner to omit the bottom surfaces of the top mounting recesses of the top communicating plate.

The top cover plate 520 is disposed in a mounting recess 5110 on the top surface 511, and covers the top communicating recess 515.

The top supporting structure 530 is fixed to the top communicating plate 510 via, for example, soldering or welding. The top supporting structure 530 is located in the top communicating recess 515. Different sides of the top supporting structure 530 are fixed to the top communicating plate 510 and the top cover plate 520 via soldering or welding, respectively. The top supporting structure 530 prevents the top communicating plate 510 from being deformed or destroyed when a vacuum pumping is performed in the top communicating recess 515 or the working fluid in the top communicating recess 515 is heated to form positive pressure. The top supporting structure 530 is, for example, a fin structure, such as an offset-strip fin. Note that besides the offset-strip fin, the top supporting structure 530 may be a skived fin, a pin fin, an I-shaped fin or a U-shape fin.

Additionally, as shown in FIG. 4, in this embodiment, a normal direction N (parallel to Z-axis direction) of the thermal contact surface 131 is substantially parallel to an extending direction E (parallel to Z-axis direction and gravitational direction G) of each communicating channel 210 of the connecting chambers 200. Each of the communicating channels 210 of the connecting chambers 200 are entirely located between the first inner space S1 and the second inner space S2. Also, the arranging direction B (parallel to X-axis direction) of the connecting chambers 200 is substantially perpendicular to the normal direction N of the thermal contact surface 131. Thus, for example, the working fluid is allowed to circulate between the first inner space S1, the communicating channels 210 and the second inner space S2 with the help of the gravity. In this way, the heat is allowed to be more efficiently transferred from the first chamber 100 to the second chamber 500 via all of the first heat sinks 300. In other words, a temperature gradient of the heat dissipation assembly 10 along positive Z-axis direction (opposite to the gravitational direction G) becomes smaller. Moreover, the arranging direction B (parallel to X-axis direction) of the first heat sinks 300 is, for example, substantially perpendicular to the normal direction N of the thermal contact surface 131. Note that two directions are substantially parallel may denote that the angle between these two directions is, for example, 0 or 180 degrees with a tolerance range equal to or smaller than ± 20 degrees; two directions are substantially perpendicular may denote that the angle between these two directions is, for example, 90 degrees with a tolerance range equal to or smaller than ± 20 degrees.

In addition, in this embodiment, a thermal conductivity of a material of the bottom cover plate 130 and the second heat sink 140 is, for example, higher than a thermal conductivity of a material of the base 110, the bottom communicating plate 120, the bottom supporting structure 150, the connecting chamber 200, the first heat sink 300 and the second chamber 500. A density of the material of the base 110, the bottom communicating plate 120, the bottom supporting structure 150, the connecting chamber 200, the first heat sink 300 and the second chamber 500 is, for example, lower than a density of the material of the bottom cover plate 130 and the second heat sink 140. For example, the bottom cover plate 130 and the second heat sink 140 may be made of copper (e.g., red copper), and the base 110, the bottom communicating plate 120, the bottom supporting structure 150, the connecting chamber 200, the first heat sink 300 and the second chamber 500 may be made of aluminum. That is, the bottom cover plate 130 and the second heat sink 140 in contact with the heat source 20 are made of a material with higher thermal conductivity, and other structures are made of a material with lower density. In this way, the thermal conductivity of the heat dissipation assembly 10 is ensured while reducing the overall weight of the heat dissipation assembly 10 as much as possible. In other embodiments, all of the first chamber, the connecting chambers, the first heat sink and the second chamber may be made of aluminum; in other embodiments, the base, the bottom communicating plate, the bottom supporting structure, the connecting chamber, the first heat sink and the second chamber may be made of copper.

Hereinafter, the operation of the heat dissipation assembly 10 will be described by referring to FIGS. 3 and 4. The heat dissipation assembly 10 of this embodiment cools the heat source 20 via thermosiphon principle or effect. The first inner space S1, the communicating channels 210 and the second inner space S2 together configure, for example, an enclosed or sealed space for the working fluid to circulate therein. In detail, liquid working fluid absorbs the heat generated by the heat source 20 in the bottom communicating recess 116 and evaporates into gas. The gaseous working fluid may flow to the top communicating recess 515 via the bottom communicating holes 121, the communicating channels 210 and the top communicating holes 514, and then condenses into liquid. The liquid working fluid may flow back to the bottom communicating recess 116 via the top communicating holes 514, the communicating channels 210 and the bottom communicating holes 121 with the help of gravity along the gravitational direction G. Note that the communicating channels 210 of each connecting chamber 200 may allow liquid working fluid, gaseous working fluid or both of liquid working fluid and gaseous working fluid to flow therein.

The first heat sinks 300 are respectively disposed between the connecting chambers 200, and the communicating channels 210 are in fluid communication with the first inner space S1. Thus, the working fluid is allowed to circulate between the first inner space S1 and the communicating channels 210 via thermosiphon principle or effect, such that the wick structures in the first inner space S1 and the communicating channels 210 are allowed to be selectively omitted. In this way, more working fluid is allowed to be accommodated in the heat dissipation assembly 10, and the flow resistance of the working fluid in the heat dissipation assembly is reduced to prevent the working fluid from drying out. Moreover, the connecting chambers 200 without wick structure is allowed to have smaller volume, thereby allowing the cooling airflow C to flow through the first heat sinks 300 uniformly. Accordingly, the heat dissipation assembly 10 is allowed to cool the heat source 20 more efficiently.

Specifically, for example, the heat dissipation assembly 10 cools the heat source 20 having a power of 800 W to have a temperature lower than 65 Celsius degrees, which proves that the heat dissipation assembly 10 is able to efficiently cool a heat source having a power equal to or higher than 1200 W.

In addition, since the wick structures are allowed to be omitted from the connecting chambers 200, the connecting chambers 200 are allowed to be made of various materials. For example, the heat dissipation assembly 10 may be made of a material with lower density to realize the lightweight thereof.

Moreover, since the second inner space S2 is in fluid communication with the first inner space S1 via the communicating channels 210 of the connecting chambers 200, the pressure distribution in the second inner space S2 is uniform, thereby allowing the working fluid to be distributed to the communicating channels 210 uniformly. In this way, the working fluid circulates between the first inner space S1, the communicating channels 210 and the second inner space S2 more efficiently, thereby further allowing the heat dissipation assembly 10 to cool the heat source 20 more efficiently.

Also, with the top communicating recess 515 in fluid communication with the top communicating holes 514, the pressure distribution in the second inner space S2 is more uniform, thereby allowing the working fluid to be distributed to the communicating channels 210 more uniformly.

With the protruding part 112, more working fluid flows to the second heat sink 140 to absorb the heat generated by the heat source 20, and thus the heat source 20 is allowed to be cooled more efficiently.

Additionally, with the recess 151 of the bottom supporting structure 150, more working fluid flows to the second heat sink 140 to absorb the heat generated by the heat source 20, and thus the heat source 20 is allowed to be cooled more efficiently. Further, with the return channels 152 of the bottom supporting structure 150, the working fluid is facilitated to flow back to the second heat sink 140 in the bottom communicating recess 116 from the communicating channels 210.

Other embodiments are described below for illustrative purposes. It is to be noted that the following embodiments use the reference numerals and a part of the contents of the above embodiments, the same reference numerals are used to denote the same or similar elements, and the description of the same technical contents is omitted. For the description of the omitted part, reference may be made to the above embodiments, and details are not described in the following embodiments.

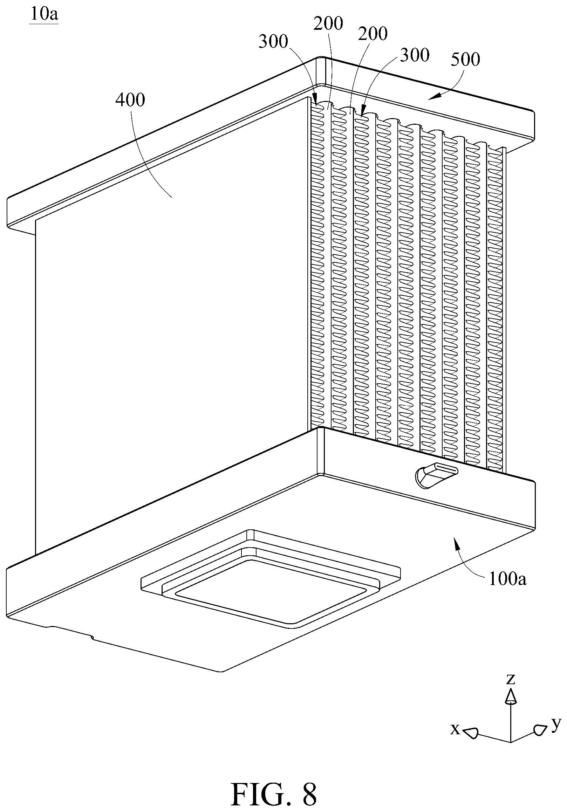

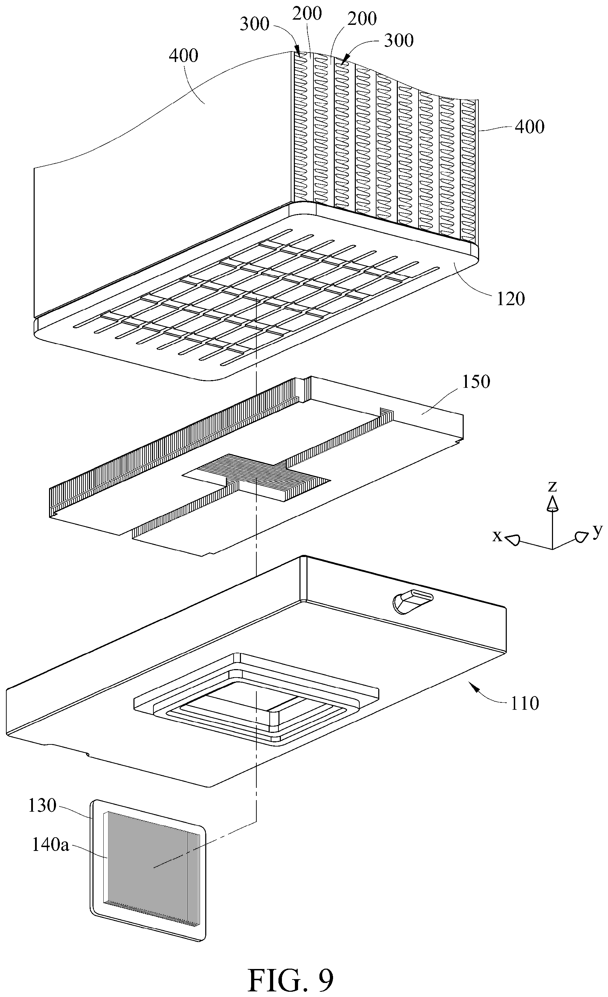

The disclosure is not limited by the type of the second heat sink. Please refer to FIGS. 8 and 9. FIG. 8 is a perspective view of a heat dissipation assembly according to a second embodiment of the disclosure. FIG. 9 is a partially enlarged exploded view of the heat dissipation assembly in FIG.8. The main difference between the heat dissipation assembly 10a of this embodiment and the heat dissipation assembly 10 of the first embodiment is the type of the second heat sink 140a of the first chamber 100a. In detail, in this embodiment, the second heat sink 140a is, for example, a skived fin. Of course, in other embodiments, besides the pin fin and the skived fin, the second heat sink may be a U-shaped fin, an I-shaped fin, an offset-strip fin, an aluminum extrusion fin or a stack fin.

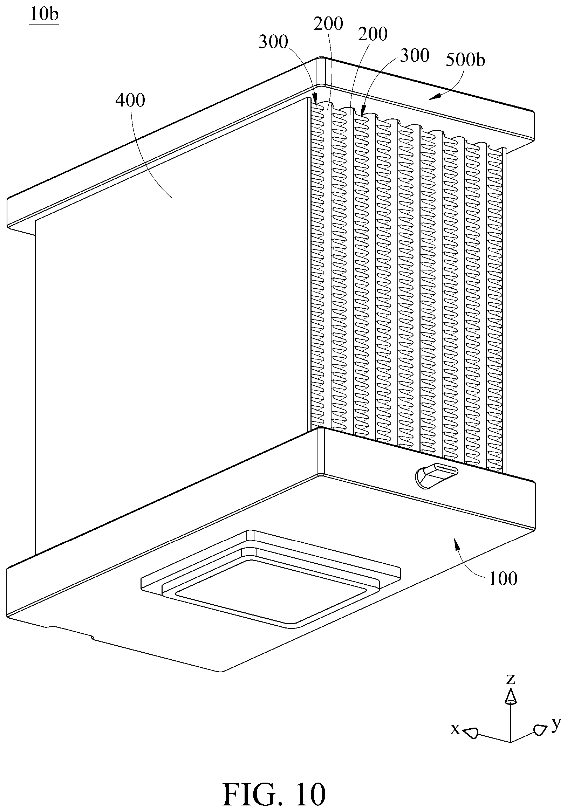

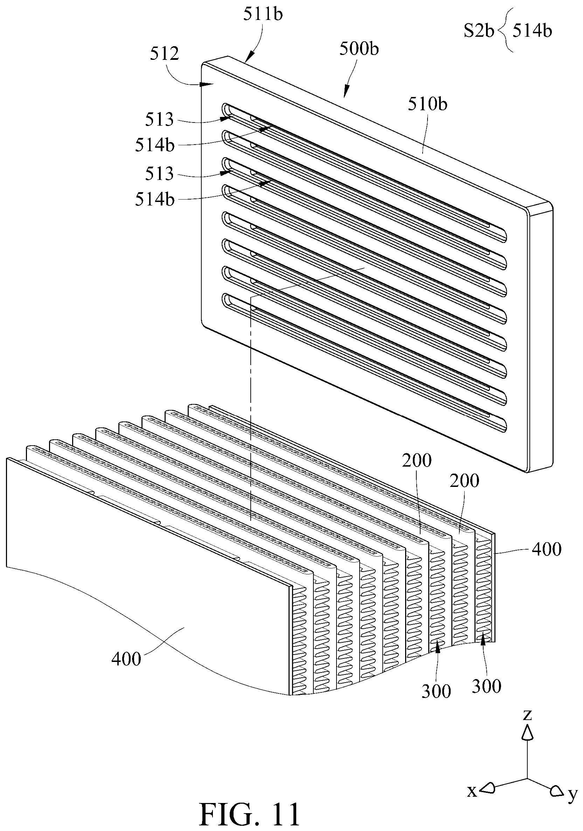

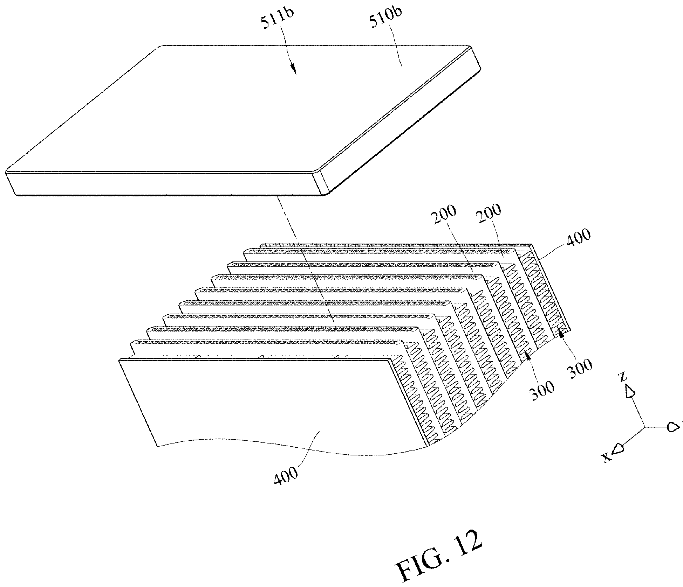

The disclosure is not limited by the configuration of the second chamber. Please refer to FIGS. 10 to 12. FIG. 10 is a perspective view of a heat dissipation assembly according to a third embodiment of the disclosure. FIG. 11 is a partially enlarged exploded view of the heat dissipation assembly in FIG.10. FIG. 12 is another partially enlarged exploded view of the heat dissipation assembly in FIG. 10. The main difference between the heat dissipation assembly 10b of this embodiment and the heat dissipation assembly 10 of the first embodiment is the configuration of the second chamber 500b. In detail, in this embodiment, the second chamber 500b does not include the top cover plate 520 and the top supporting structure 530 in the first embodiment. In addition, the second inner space S2b includes the top communicating holes 514 but does not include the top communicating recess 515 in the first embodiment. That is, the top surface 511b of the top communicating plate 510b is in, for example, a flat shape. The top communicating holes 514b are, for example, blind holes or recesses that do not extend to the top surface 511b.

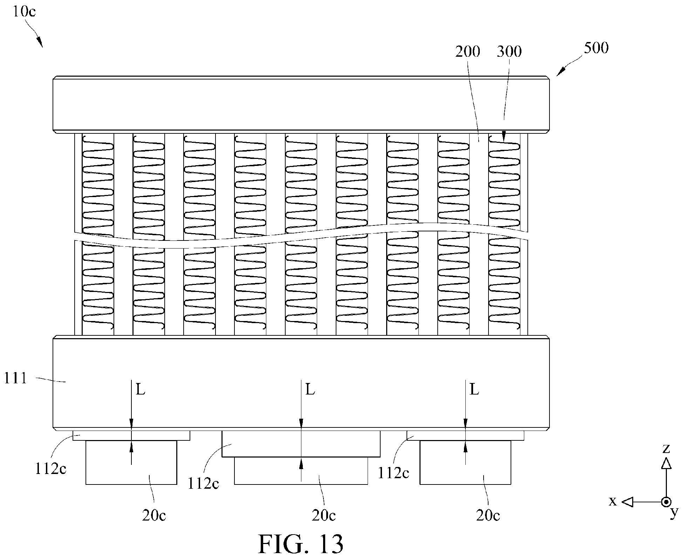

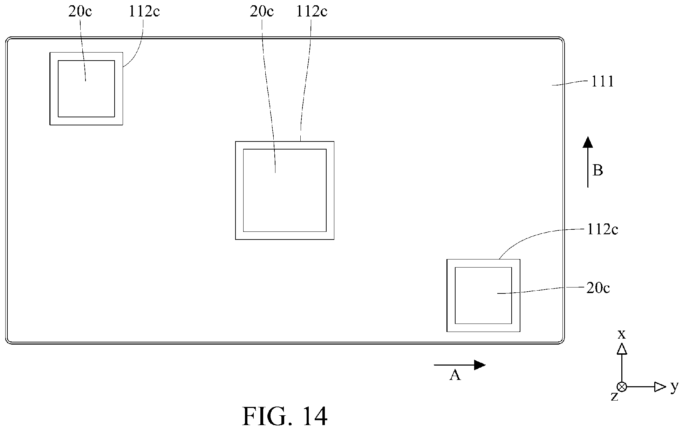

The disclosure is not limited by the number of the protruding part. Please refer to FIGS. 13 and 14. FIG. 13 is a side view of a heat dissipation assembly according to a fourth embodiment of the disclosure and heat sources. FIG. 14 is a bottom view of the heat sources and the heat dissipation assembly in FIG. 13. The main difference between the heat dissipation assembly 10c of this embodiment and the heat dissipation assembly 10 of the first embodiment is the number of protruding parts 112c. In detail, in this embodiment, there are a plurality of protruding parts 112c. The bottom cover plate 130 and the second heat sink 140 is FIG. 3 may be disposed in the protruding parts 112c, such that the heat dissipation assembly 10c is configured to cool the heat sources 20c. In addition, the protruding parts 112c, for example, has different protruding lengths L relative to the body part 111 so as to cooperate with the heat sources 20c of different heights. Also, the protruding parts 112c, for example, are misaligned with one another along the arranging direction B (parallel to X-axis direction) of the connecting chambers 200 and the arranging direction A (parallel to Y-axis direction) of the communicating channels (not shown but may refer to the communicating channels 210 in FIG. 5), and thus are able to be applied to the heat sources 20c arranged in a specific manner.

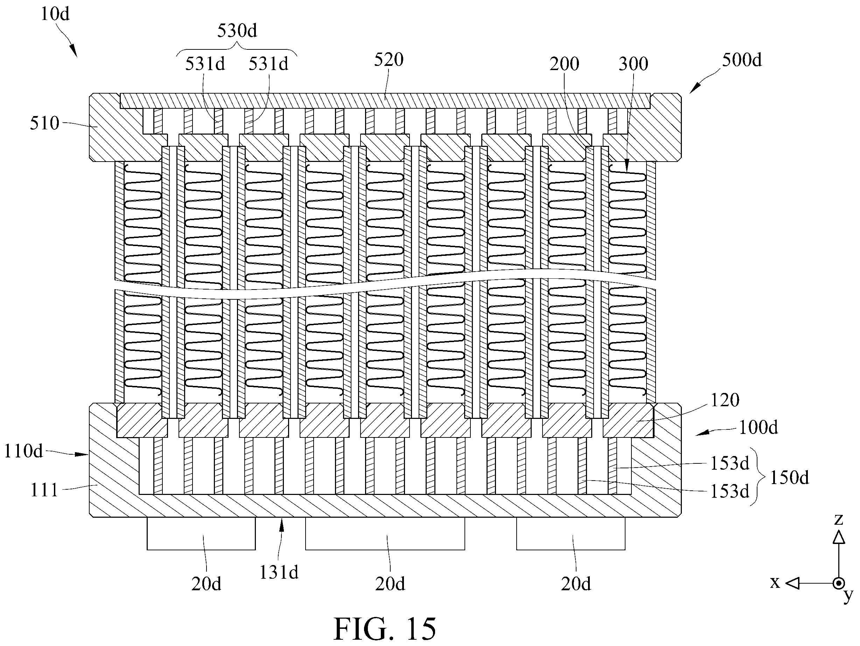

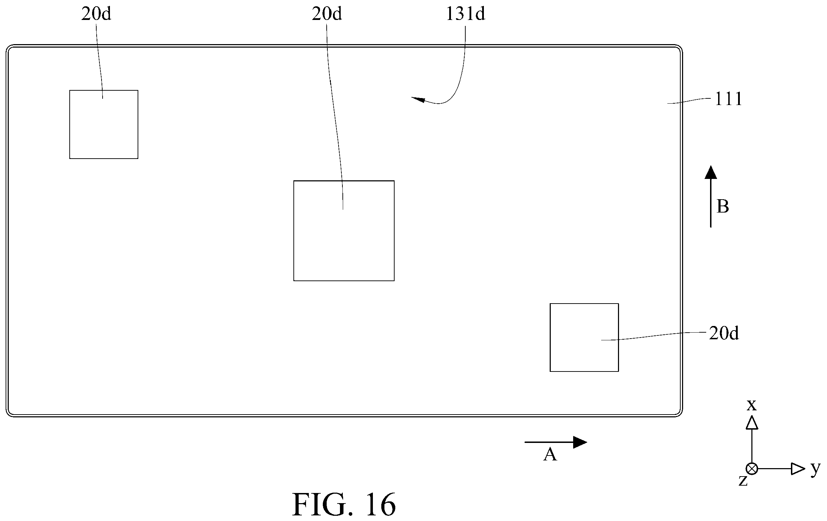

The base of the disclosure is not limited to including the protruding part, and the disclosure is not limited by the configurations of the bottom supporting structure and the top supporting structure. Please refer to FIGS. 15 and 16. FIG. 15 is a cross-sectional view of a heat dissipation assembly according to a fifth embodiment of the disclosure and heat sources. FIG. 16 is a bottom view of the heat sources 20d and the heat dissipation assembly in FIG. 15. The main difference between the heat dissipation assembly 10d of this embodiment and the heat dissipation assembly 10 of the first embodiment is the configurations of the first chamber 100d and the second chamber 500d. In detail, in this embodiment, a base 110d includes the body part 111 but does not include the protruding part 112, the bottom cover plate 130 and the second heat sink 140 in the first embodiment, and a bottom supporting structure 150d includes a plurality of supporting columns 153d spaced apart from one another. Two opposite ends of each supporting column 153d are fixed to the body part 111 and the bottom communicating plate 120, respectively. The supporting columns 153d are made of a thermally conductive material, such as copper or aluminum, and replace the second heat sink 140 in the first embodiment as thermally conductive media. Similarly, in this embodiment, the top supporting structure 530d includes a plurality of supporting columns 531d spaced apart from one another. Two opposite ends of each supporting column 531d are fixed to the top communicating plate 510 and the top cover plate 520, respectively. The supporting columns 153d and 531d practically are spaced apart from one another along X-axis direction and Y-axis direction, and thus the circulation of the working fluid is not disturbed thereby.

In addition, in this embodiment, a thermal contact surface 131d is located on the body part 111 and configured to be in thermal contact with the heat sources 20d. The heat sources 20d, for example, are misaligned with one another along the arranging direction B (parallel to X-axis direction) of the connecting chambers 200 and the arranging direction A (parallel to Y-axis direction) of the communicating channels (not shown but may refer to the communicating channels 210 in FIG. 5).

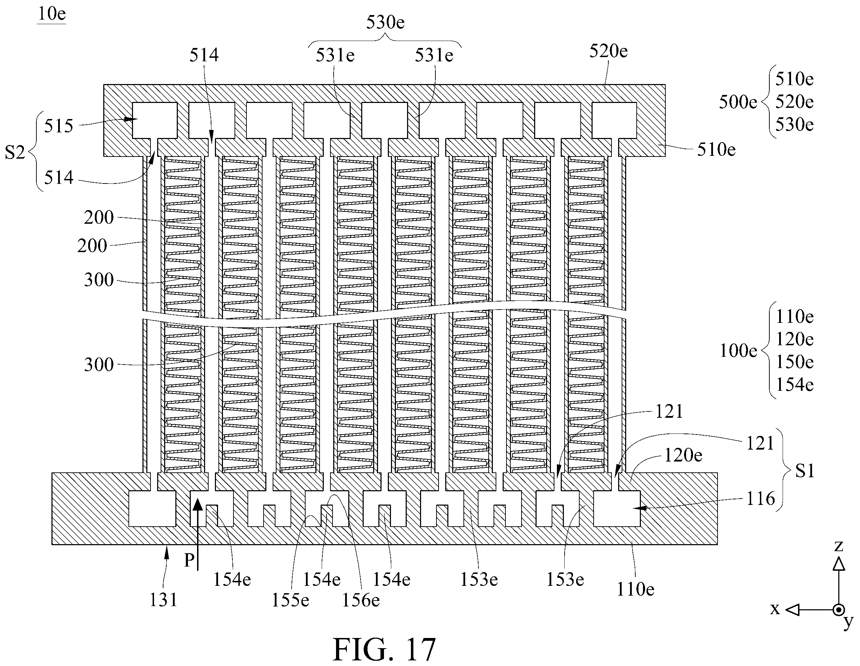

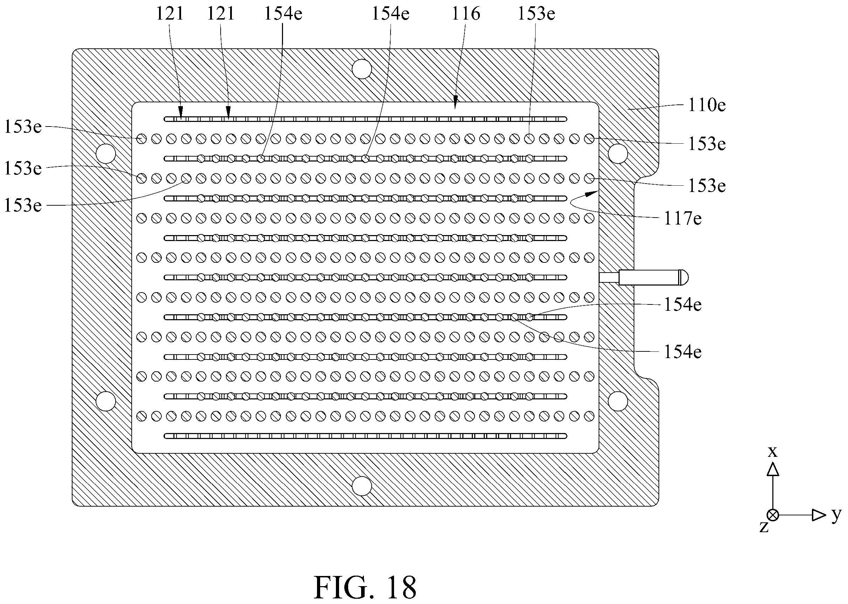

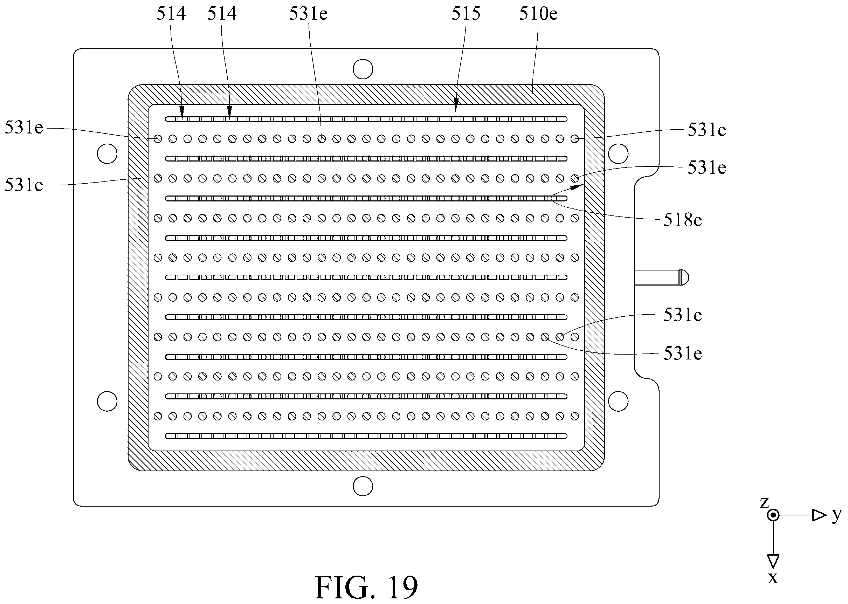

The first chamber and the second chamber of the disclosure are not limited to being multiple parts that are assembled together. Please refer to FIGS. 17 to 19. FIG. 17 is a cross-sectional view of a heat dissipation assembly according to a sixth embodiment of the disclosure. FIG. 18 is another cross-sectional view of the heat dissipation assembly in FIG. 17. FIG. 19 is still another cross-sectional view of the heat dissipation assembly in FIG. 17. The main difference between the heat dissipation assembly 10e of this embodiment and the heat dissipation assembly 10d of the fifth embodiment is in the structure of a first chamber 100e and the structure of a second chamber 500e. Specifically, in this embodiment, the heat dissipation assembly 10e includes the first chamber 100e, the connecting chambers 200, the first heat sinks 300 and the second chamber 500e. The connecting chambers 200 are disposed on a side of the first chamber 100e. The second chamber 500e is disposed on sides of the connecting chambers 200 located away from the first chamber 100e.

In this embodiment, the first chamber 100e, the connecting chambers 200 and the second chamber 500e are, for example, integrally formed as a single piece via 3D printing. In some embodiments, the first chamber 100e, the connecting chambers 200 and the second chamber 500e may partially be integrally formed as a single piece via 3D printing due to the manufacturing limitation(s).

In this embodiment, the first chamber 100e includes a base 110e, a bottom communicating plate 120e and a bottom supporting structure 150e, and has the first inner space S1. The first inner space S1 includes the bottom communicating recess 116 and the bottom communicating holes 121. The bottom communicating recess 116 is located on the base 110e. The bottom communicating plate 120e is disposed on a side of the base 110e. The bottom communicating holes 121 are located on the bottom communicating plate 120e, and in fluid communication with the bottom communicating recess 116. The bottom supporting structure 150e is disposed in the bottom communicating recess 116, and includes a plurality of bottom supporting columns 153e spaced apart from each other. Two opposite ends of each bottom supporting column 153e are connected to the base 110e and the bottom communicating plate 120e. Thus, the working fluid is allowed to flow through the gaps between the bottom supporting columns 153e, thereby facilitating the flow of the working fluid in the bottom communicating recess 116. Also, for example, the base 110e, the bottom communicating plate 120e and the bottom supporting structure 150e are allowed to be integrally formed as a single piece. In this way, the cooling capacity of the heat dissipation assembly 10e is improved while enhancing the structural strength of the first chamber 100e. In addition, the base 110e has the thermal contact surface 131.

In this embodiment, the bottom supporting columns 153e are spaced apart from the bottom communicating holes 121. Thus, the bottom supporting columns 153e is prevented from disturbing the vaporized working fluid from flowing into the connecting chambers 200 via the bottom communicating holes 121.

In this embodiment, a part of the bottom supporting columns 153e are located between adjacent bottom communicating holes 121, and another apart of the bottom supporting columns 153e are located between the bottom communicating holes 121 and a side surface 117e of the base 110e forming the bottom communicating recess 116.

In this embodiment, the first chamber 100e further includes a plurality of thermally conductive columns 154e disposed in the bottom communicating recess 116. The thermally conductive columns 154e each have a heat absorbing end 155e and a heat releasing end 156e. The heat absorbing ends 155e of the thermally conductive columns 154e are connected to the base 110e. The heat releasing ends 156e of the thermally conductive columns 154e are spaced apart from the bottom communicating plate 120e. The thermally conductive columns 154e may efficiently transfer the heat generated by the heat source (not shown) to the working fluid in the bottom communicating recess 116, thereby facilitating the vaporization of the working fluid.

In this embodiment, the thermally conductive columns 154e protrude inwards from the base 110e along a protruding direction P. The thermally conductive columns 154e at least partially overlap with the bottom communicating holes 121 along the protruding direction P, respectively. Thus, the thermally conductive columns 154e absorb the heat so as to allow the vaporized working fluid to flowing into the connecting chambers 200 via the bottom communicating holes 121 more efficiently.

In this embodiment, the second chamber 500e includes a top communicating plate 510e, a top cover plate 520e and a top supporting structure 530e. The second inner space S2 includes a top communicating recess 515 and the top communicating holes 514. The top communicating recess 515 is located on the top communicating plate 510e. The top cover plate 520e is disposed on a side of the top communicating plate 510e. The top communicating holes 514 are located on the top cover plate 520e, and are in fluid communication with the top communicating recess 515. The top supporting structure 530e is disposed in the top communicating recess 515, and includes a plurality of top supporting columns 531e spaced apart from each other. Two opposite ends of each top supporting columns 531e are connected to the top communicating plate 510e and the top cover plate 520e, respectively.

In this embodiment, the top supporting columns 531e are spaced apart from the top communicating holes 514. Thus, the working fluid (e.g., the gaseous working fluid) flowing from the top communicating holes 514 to the top communicating recess 515 is prevented from being directly blocked by the top supporting columns 531e.

In this embodiment, a part of the top supporting columns 531e are located between adjacent top communicating holes 514, and another part of the top supporting columns 531e are located between the top communicating holes 514 and a side surface 518e of the top communicating plate 510e forming the top communicating recess 515.

In this embodiment, the bottom supporting columns 153e, the thermally conductive columns 154e and the top supporting columns 531e are, for example, cylindrical, and thus the manufacture thereof is facilitated, but the disclosure is not limited thereto. In other embodiments, the bottom supporting columns and the thermally conductive columns may be in an arbitrary shape, such as triangular prism, teardrop shape, and quadrilateral prism.

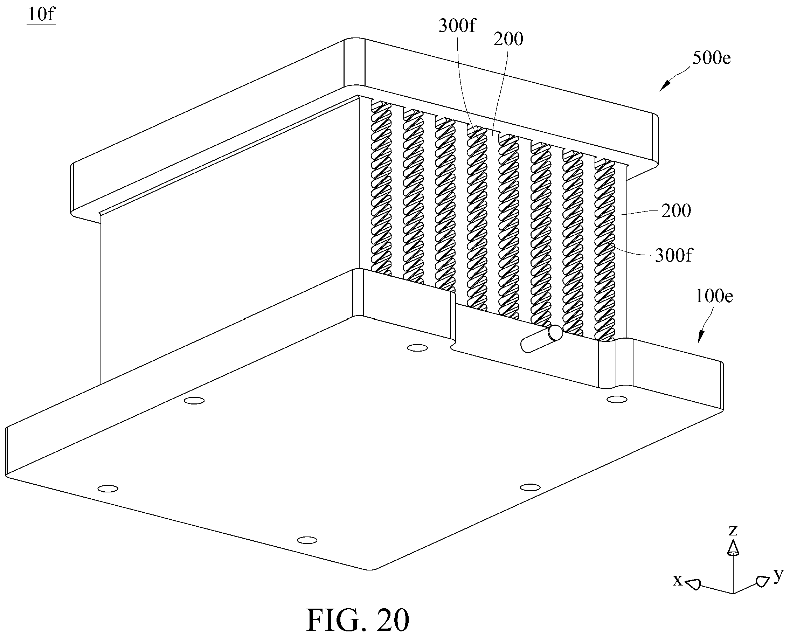

In this embodiment, the first heat sinks 300 are fixed to the connecting chambers 200 via, for example, soldering or welding, but the disclosure is not limited thereto. Please refer to FIG. 20. FIG. 20 is a perspective view of a heat dissipation assembly according to a seventh embodiment of the disclosure. The only difference between the heat dissipation assembly 10f of this embodiment and the heat dissipation assembly 10e of the sixth embodiment is the connection relationship between the connecting chambers 200 and the first heat sinks 300f. Specifically, in this embodiment, the heat dissipation assembly 10f includes the first chamber 100e, the connecting chambers 200, a plurality of first heat sinks 300f and the second chamber 500e. In this embodiment, the connecting chambers 200 and the first heat sinks 300f are, for example, integrally formed as a single piece. That is, the first chamber 100e, the connecting chambers 200, the first heat sinks 300f and the second chamber 500e are, for example, integrally formed as a single piece.

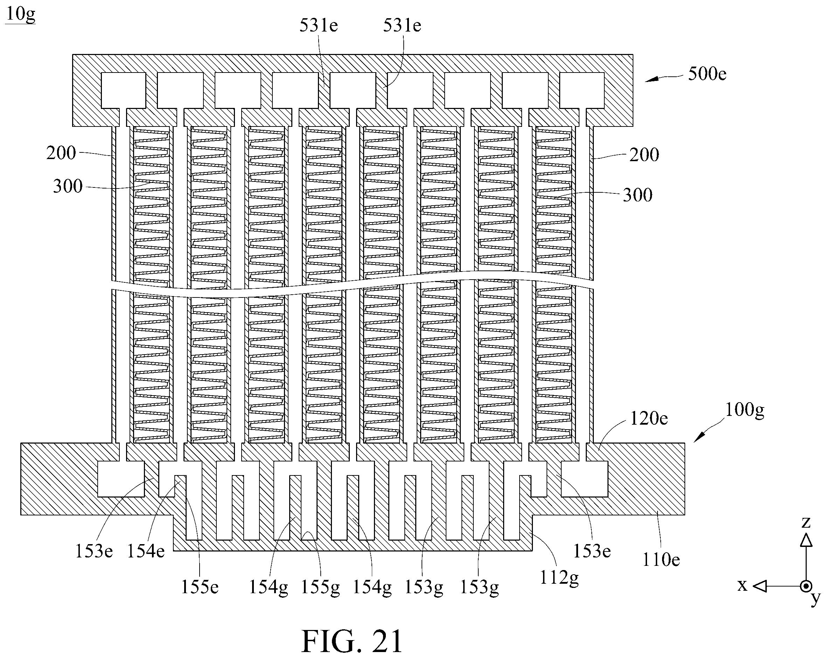

Please refer to FIG. 21. FIG. 21 is a perspective view of a heat dissipation assembly according to an eighth embodiment of the disclosure. The main difference between the heat dissipation assembly 10g of this embodiment and the heat dissipation assembly 10e of the sixth embodiment is in that a first chamber 100g of this embodiment further includes a protruding part 112g. The protruding part 112g protrudes from a side of the base 110e located away from the bottom communicating plate 120e. Two opposite ends of each of a part of the plurality of bottom supporting columns 153e are connected to the base 110e and the bottom communicating plate 120e, respectively. Two opposite ends of each of another part of the plurality of bottom supporting columns 153g are connected to the protruding part 112g and the bottom communicating plate 120e, respectively. The heat absorbing ends 155e of a part of the plurality of thermally conductive columns 154e are connected to the base 110e. The heat absorbing ends 155g of another part of the plurality of thermally conductive columns 154g are connected to the protruding part 112g. With the protruding part 112g, the heat dissipation assembly 10e may, for example, be configured for the heat source (not shown) with lower height.

According to the heat dissipation assembly disclosed by above embodiments, the first heat sinks are respectively disposed between the connecting chambers, and the communicating channels are in fluid communication with the first inner space. Thus, the working fluid is allowed to circulate between the first inner space and the communicating channels via thermosiphon principle or effect, such that the wick structures in the first inner space and the communicating channels are allowed to be selectively omitted. In this way, more working fluid is allowed to be accommodated in the heat dissipation assembly, and the maximum amount of heat that the heat dissipation assembly is able to conduct and the heat capacity per unit volume of the heat dissipation assembly are significantly increased. Moreover, the connecting chambers without wick structure is allowed to have smaller volume, thereby allowing the cooling airflow to flow through the first heat sinks uniformly. Accordingly, the heat dissipation assembly is allowed to cool the heat source more efficiently.

In addition, since the wick structures are allowed to be omitted from the connecting chambers, the connecting chambers are allowed to be made of various materials. For example, the heat dissipation assembly may be made of a material with lower density to realize the lightweight thereof.

Moreover, since the second inner space is in fluid communication with the first inner space via the communicating channels of the connecting chambers, the pressure distribution in the second inner space is uniform, thereby allowing the working fluid to be distributed to the communicating channels uniformly. In this way, the working fluid circulates between the first inner space, the communicating channels and the second inner space more efficiently, thereby further allowing the heat dissipation assembly to cool the heat source more efficiently.

In addition, the bottom supporting columns are spaced apart from each other and two opposite ends of each bottom supporting column are connected to the base and the bottom communicating plate. Thus, the working fluid is allowed to flow through the gaps between the bottom supporting columns, thereby facilitating the flow of the working fluid in the bottom communicating recess. Also, for example, the base, the bottom communicating plate and the bottom supporting structure are allowed to be integrally formed as a single piece. In this way, the cooling capacity of the heat dissipation assembly is improved while enhancing the structural strength of the first chamber.

It will be apparent to those skilled in the art that various modifications and variations can be made to the disclosed embodiments. It is intended that the specification and examples be considered as exemplary only, with a true scope of the disclosure being indicated by the following claims and their equivalents.

## Claims

1. A heat dissipation assembly (10, 10a, 10b, 10c, 10d, 10e, 10f, 10g), configured to be in thermal contact with at least one heat source (20, 20c, 20d) and comprising:
a first chamber (100, 100a, 100d, 100e, 100g), having a thermal contact surface (131, 131d) and a first inner space (S1), the thermal contact surface is configured to be in thermal contact with the at least one heat source;
at least three connecting chambers (200), each has at least one communicating channel (210) in fluid communication with the first inner space;
at least two first heat sinks (300), disposed between the at least three connecting chambers, respectively; and
a second chamber (500, 500b, 500d, 500e), having a second inner space (S2, S2b), wherein the second inner space is in fluid communication with the first inner space at least via the at least one communicating channel of at least one of the connecting chambers;
wherein, a normal direction (N) of the thermal contact surface is substantially parallel to an extending direction (E) of the at least one communicating channel of each of the at least three connecting chambers;
wherein, the at least one communicating channel of each of the at least three connecting chambers is entirely located between the first inner space and the second inner space; and
wherein, an arranging direction (B) of the at least three connecting chambers is substantially perpendicular to the normal direction of the thermal contact surface.

2. The heat dissipation assembly according to claim 1, wherein the at least three connecting chambers each comprise a plurality of communicating channels arranged along an arranging direction (A) and spaced apart from each other, the second inner space is in fluid communication with the first inner space via the plurality of communicating channels of the at least three connecting chambers.

3. The heat dissipation assembly according to claim 2, wherein the second chamber further has a bottom surface (512), the second inner space comprises a plurality of top communicating holes (514, 514b) arranged along the arranging direction of the plurality of communicating channels and located on the bottom surface, and the plurality of top communicating holes are in fluid communication with the plurality of communicating channels of the at least three connecting chambers, respectively.

4. The heat dissipation assembly according to claim 3, wherein the second chamber comprises a top communicating plate (510, 510b), a top cover plate (520) and a top supporting structure (530, 530d), the second inner space further comprises a top communicating recess (515), the bottom surface and the plurality of top communicating holes are located on the top communicating plate, the top communicating plate further has a top surface (511, 511b) facing away from the bottom surface, the top communicating recess is recessed from the top surface and in fluid communication with the plurality of top communicating holes, the top cover plate is disposed in a mounting recess on the top surface and covers the top communicating recess, and the top supporting structure is fixed to the top communicating plate and located in the top communicating recess.

5. The heat dissipation assembly according to claim 4, wherein the top communicating plate further has a plurality of top mounting recesses (513) located on the bottom surface, the plurality of top communicating holes penetrate through a plurality of bottom surfaces (516) of the plurality of top mounting recesses and a bottom surface (517) of the top communicating recess, respectively, and sides of the at least three connecting chambers are fixed in the plurality of top mounting recesses, respectively.

6. The heat dissipation assembly according to claim 2, wherein the first chamber comprises a base (110, 110d), a bottom communicating plate (120), a bottom cover plate (130), a second heat sink (140, 140a) and a bottom supporting structure (150, 150d), the first inner space comprises a bottom communicating recess (116) and a plurality of bottom communicating holes (121), the base has a top surface (113) and a bottom surface (114) facing away from each other, the bottom communicating recess is recessed inwards from the top surface, the bottom communicating plate is disposed in the bottom communicating recess and the plurality of bottom communicating holes are located on the bottom communicating plate, the plurality of bottom communicating holes extend along the arranging direction of the plurality of communicating channels, the plurality of communicating channels of the at least three connecting chambers are in fluid communication with the bottom communicating recess via the plurality of bottom communicating holes, respectively, the bottom cover plate is disposed on the bottom surface and is configured to be in thermal contact with the at least one heat source, the second heat sink is disposed on the bottom cover plate and located in the bottom communicating recess, and the bottom supporting structure is fixed to the base and located in the bottom communicating recess.

7. The heat dissipation assembly according to claim 6, wherein the bottom supporting structure has a recess (151) and two return channels (152), the two return channels are in fluid communication with the recess and located on two opposite sides of the recess, respectively, the two return channels extend along the arranging direction of the plurality of communicating channels, and the second heat sink is located between the recess and the bottom cover plate.

8. The heat dissipation assembly according to claim 1, further comprising two air blocking plates (400), wherein the at least two first heat sinks comprise at least four first heat sinks, the at least three connecting chambers are located between the at least four first heat sinks, respectively, the two air blocking plates are disposed on two of the at least four first heat sinks, respectively, and the at least three connecting chambers and the at least four first heat sinks are located between the two air blocking plates.

9. The heat dissipation assembly according to claim 1, wherein the first chamber (100e, 100g) comprises:
a base (110e), having a bottom communicating recess (116), wherein the thermal contact surface (131) is located on the base;
a bottom communicating plate (120e), disposed on a side of the base and having a plurality of bottom communicating holes (121), the plurality of bottom communicating holes are in fluid communication with the bottom communicating recess, the bottom communicating recess and the plurality of bottom communicating holes together form the first inner space; and
a bottom supporting structure (150e), disposed in the bottom communicating recess and comprising a plurality of bottom supporting columns (153e, 153g) spaced apart from each other, wherein two opposite ends of each of the plurality of bottom supporting columns are connected to the base and the bottom communicating plate, respectively.

10. The heat dissipation assembly according to claim 9, wherein the plurality of bottom supporting columns are spaced apart from the plurality of bottom communicating holes.

11. The heat dissipation assembly according to claim 9, wherein the first chamber further comprises a plurality of thermally conductive columns (154e, 154g) disposed in the bottom communicating recess, the plurality of thermally conductive columns each have a heat absorbing end (155e, 155g) and a heat releasing end (156e), the heat absorbing ends of the plurality of thermally conductive columns are connected to the base, the heat releasing ends of the plurality of thermally conductive columns are spaced apart from the bottom communicating plate.

12. The heat dissipation assembly according to claim 11, wherein the plurality of thermally conductive columns protrude inwards from the base along a protruding direction (P), he plurality of thermally conductive columns at least partially overlap with the plurality of bottom communicating holes along the protruding direction, respectively.

13. The heat dissipation assembly according to claim 11, wherein the first chamber further comprises a protruding part (112g), the protruding part protrudes from a side of the base located away from the bottom communicating plate, two opposite ends of each of a part of the plurality of bottom supporting columns (153e) are connected to the base and the bottom communicating plate, respectively, two opposite ends of each of another part of the plurality of bottom supporting columns (153g) are connected to the protruding part and the bottom communicating plate, respectively, the heat absorbing ends (155e) of a part of the plurality of thermally conductive columns (154e) are connected to the base, the heat absorbing ends (155g) of another part of the plurality of thermally conductive columns (154g) are connected to the protruding part.

14. The heat dissipation assembly according to claim 9, wherein the second chamber (500e) comprises:
a top communicating plate (510e), having a top communicating recess (515);
a top cover plate (520e), disposed on a side of the top communicating plate and having a plurality of top communicating holes (514), wherein the plurality of top communicating holes are in fluid communication with the top communicating recess and form the second inner space together with the top communicating recess, the communicating channels of the plurality of connecting chambers are in fluid communication with the plurality of top communicating holes, respectively; and
a top supporting structure (530e), disposed in the top communicating recess and comprising a plurality of top supporting columns (531e) spaced apart from each other, two opposite ends of each of the plurality of top supporting columns are connected to the top communicating plate and the top cover plate, respectively.

15. The heat dissipation assembly according to claim 14, wherein the plurality of top supporting columns are spaced apart from the plurality of top communicating holes.
